# FASCICULE DE BREVET EUROPEEN

(11) **EP 0 982 770 B1**
(45) Date de publication et mention de la délivrance du brevet: **09.02.2011**
(21) Numéro de dépôt: 99402101.2
(22) Date de dépôt: 23.08.1999
(51) Int. Cl.: H01L 21/762

(54) **Procédé d'isolation physique de régions d'une plaque de substrat**
Physikalische Isolation von Gebieten eines Halbleitersubstrats
Physical isolation of regions of a semiconductor substrate

(30) Priorité: 25.08.1998 FR 9810687
(43) Date de publication de la demande: 01.03.2000
(73) Titulaire: Commissariat à l'Énergie Atomique et aux Énergies Alternatives, 75015 Paris (FR)
(72) Inventeur: Gidon, Pierre, 38130 Echirolles (FR)
(74) Mandataire: Audier, Philippe André

(56) Documents cités:
- US-A- 4 612 408
- US-A- 5 064 771
- CHOW L A ET AL: "The processing and characterization of hybrid silica-based xerogel films" , LOW-DIELECTRIC CONSTANT MATERIALS III. SYMPOSIUM, LOW-DIELECTRIC CONSTANT MATERIALS III. SYMPOSIUM, SAN FRANCISCO, CA, USA, 1-4 APRIL 1997 , ISBN 1-55899-380-0, 1997, PITTSBURGH, PA, USA, MATER. RES. SOC, USA, PAGE(S) 105 - 110 XP002102180

## Description

### Domaine technique

La présente invention concerne un procédé de préparation d'une plaque de substrat et plus précisément d'isolation physique de régions d'une telle plaque.

Au sens de l'invention, on entend par isolation physique des régions, une séparation entre les différentes régions, qui permette d'isoler électriquement et/ou optiquement, et/ou magnétiquement et/ou mécaniquement (en particulier piezoélectriquement) lesdites régions.

Selon le type d'isolation prévu, il est possible de trouver des applications de l'invention dans des domaines très variés de l'industrie.

A titre d'exemple, une plaque de substrat semiconducteur avec des régions électriquement isolées peut être mise en oeuvre pour la réalisation de composants électroniques, et en particulier des composants de commutation de puissance.

De la même façon, une plaque de substrat comprenant des régions de matériau transparent ou biréfringent, peut être utilisée pour la réalisation de guides d'onde, de lentilles ou de commutateurs optiques. De la même façon encore, une plaque de substrat comprenant des régions en matériaux piezoélectriques ou électrooptiques peut être utilisée pour réaliser des matrices de capteurs ou d'actionneurs

L'invention peut aussi être mise en oeuvre pour dans le domaine mécanique ou magnétique pour l'intégration de différents capteurs tels que des capteurs de pression, d'accélération, de champ magnétique ou autres.

### Etat de la technique antérieure

Dans le domaine de l'électronique de puissance intégrée, la réalisation des équipements fait de moins en moins appel à des composants discrets formés dans toute l'épaisseur d'une plaque de substrat, mais privilégie des technique d'intégration, propres à la microélectronique, dans lesquelles les composants et les connexions entre composants sont formés à la surface du substrat. Ces techniques sont habituellement désignées par "Swart Power".

Des mesures particulières pour assurer une isolation électrique suffisante entre les composants conduisent à des modifications de la forme des composants et des préparations souvent complexes des supports d'intégration.

Par ailleurs, les impératifs d'isolation sont souvent contraires aux exigences d'une intégration toujours plus dense.

A titre d'exemple, US 5, 064, 771 décrit un procédé de fabrication d'un réseau de pavés semiconducteurs monocristallins séparés mutuellement par des parois isolantes. Ce procédé de fabrication comprend la gravure de tranchées non traversantes dans la face avant d'un substrat, l'emplissage de ces tranchées d'un matériau isolant, le report de la face avant du substrat sur un support et l'amincissement du substrat par la face arrière pour mettre à nu le fond des tranchées.

Par ailleurs, toujours à titre d'exemple, US 4,612,408 décrit la fabrication d'un réseau de cellules solaires. Ce procédé comprend la formation d'une pluralité de cellules dans une plaque de silicium, le report de la plaque sur un support au moyen d'une résine adhésive et le découpage de tranchées dans la plaque de silicium pour séparer les cellules.

L'isolation des composants électroniques plus traditionnels, formés dans toute l'épaisseur du substrat de support, requiert également des opérations de préparation complexes du substrat. Ces opérations comportent par exemple la diffusion d'impuretés dopantes dans des régions sélectionnées du substrat pour y former des barrières de potentiel. Elles peuvent comporter également la formation de parois diélectriques avant la réalisation des composants.

Des problèmes d'isolation de composants se posent également pour les circuits optiques dans lesquels il convient d'éviter toute diffusion ou propagation de lumière parasite entre les différents composants.

Enfin, dans la fabrication de capteurs ou de transducteurs magnétiques ou mécaniques, des précautions complexes d'isolation magnétique ou mécanique doivent être prises.

Les difficultés évoquées ci-dessus sont encore accentuées lorsqu'il est prévu d'intégrer sur une même plaque de substrat des composants de différentes catégories dont les exigences d'isolation sont différentes. Ceci est le cas, par exemple, lorsque doivent être combinés des circuits de microélectronique et des circuits d'électronique de puissance, des circuits électronique et des circuits optiques, ou des capteurs.

### Exposé de l'invention

La présente invention a pour but de proposer un procédé d'isolation physique de régions d'une plaque de substrat ne présentant pas les difficultés mentionnées ci-dessus.

Un but est en particulier de proposer un tel procédé permettant de réaliser une isolation électrique, optique, mécanique et/ou magnétique selon les exigences de la fabrication des circuits envisagés.

Un but est encore de proposer un tel procédé particulièrement adapté à des circuits électroniques de puissance, capable d'isoler des tensions élevées.

Un autre but est de proposer un procédé d'isolation dont la mise en oeuvre soit simple, qui puisse avoir lieu avant, pendant ou après la mise en place de composants dans ou sur les régions de la plaque de substrat, et qui soit compatible avec les contraintes d'une forte intégration des composants.

Pour atteindre ces buts, l'invention a plus précisément pour objet un procédé d'isolation physique de régions d'une plaque de substrat, comprenant les étapes suivantes :
a) collage du substrat sur un support au moyen d'un moyen adhésif permettant un décollage ultérieur,
b) formation dans le substrat de tranchées, les tranchées délimitant des régions du substrat,
c) mise en place dans les tranchés d'un matériau de liaison liquide, susceptible d'être solidifié et d'adhérer, à l'état solide, à la plaque de substrat,
d) solidification du matériau de liaison.

Le choix du matériau de liaison peut être adapté en fonction du type d'isolation recherché. En particulier, pour une isolation électrique un matériau diélectrique tel qu'un polymère, un sol-gel ou un époxy, peut, par exemple, être retenu.

Les tranchées peuvent être traversantes ou non. Elles sont pratiquées de préférence par sciage mais peuvent également être gravées chimiquement ou obtenues par une combinaison d'opérations de sciage et de gravure. Les tranchées peuvent aussi être pratiquées selon d'autres techniques telles que les techniques de découpage par laser ou par jet d'eau.

Le support utilisé lors de l'étape a) permet de conserver efficacement la cohésion des régions de la plaque de substrat jusqu'à la mise en place et la solidification du matériau de liaison.

Selon une mise en oeuvre particulière de l'invention, appropriée en particulier à l'isolation de tensions électriques entre les régions de substrat, on peut pratiquer des évasements à la surface de la plaque de substrat, coïncidant avec les tranchées.

En particulier, on peut pratiquer dans la plaque de substrat des rainures à flancs obliques formant lesdits évasements.

Les évasements peuvent être formés avant ou après les tranchées, à condition, bien sûr, que l'extrémité des tranchées coïncide avec les évasements.

Les évasements peuvent être pratiqués à une seule ou aux deux extrémités des tranchées. Ils sont pratiqués aux deux extrémités en particulier lorsque les tensions électriques entre les régions de substrat voisines risquent de s'inverser.

La réalisation des évasements aux deux extrémités des tranchées peut avoir lieu selon les étapes opératoires successives suivantes :
- formation de premières rainures à flancs évasés dans une première face de la plaque de substrat,
- formation à partir de la première face de premières tranchées non traversantes dans la plaque, coïncidant avec les premières rainures,
- garniture des premières tranchées avec le matériau de liaison,
- décollement du substrat et du support,
- formation de deuxièmes rainures à flancs évasés dans une deuxième face de la plaque de substrat, opposée à ladite première face, les deuxièmes rainures étant colinéaires aux premières rainures,
- formation à partir de la deuxième face de deuxièmes tranchées débouchant dans les premières tranchées, et coïncidant avec les deuxièmes rainures,
- garniture des deuxièmes tranchées de matériau de liaison.

On entend par garniture, la mise en place et la solidification du matériau de liaison.

Afin d'adapter l'isolation au type de composants réalisés dans les régions de la plaque de substrat, il est possible de tapisser avec un revêtement approprié les parois des tranchées avant la mise en place du matériau de liaison.

A titre d'exemple pour une meilleure répartition de champ électrique, les parois des tranchées peuvent être tapissées d'une fine couche de matériau présentant une conductivité électrique déterminée.

Dans une utilisation du substrat pour la réalisation de composants optiques, les parois peuvent être tapissées d'une couche métallique formant un miroir, ou au contraire, d'une structure multicouche diélectrique formant un revêtement antireflet optique.

L'invention concerne également l'utilisation d'une plaque de substrat selon le procédé décrit ci-dessus pour la fabrication de barrettes ou de matrices de diodes ou de transistors isolés les uns des autres, pour la fabrication de barrettes ou de matrices de circuits électroniques isolés électriquement les uns des autres ou pour la fabrication d'un composant formé de diodes et/ou de transistors, et/ou de circuits électroniques, et/ou de capteurs ou actionneurs isolés les uns des autres.

D'autres caractéristiques et avantages de l'invention ressortiront mieux de la description qui va suivre, en référence aux figures des dessins annexés. Cette description est donnée à titre purement illustratif et non limitatif.

### Brève description des figures

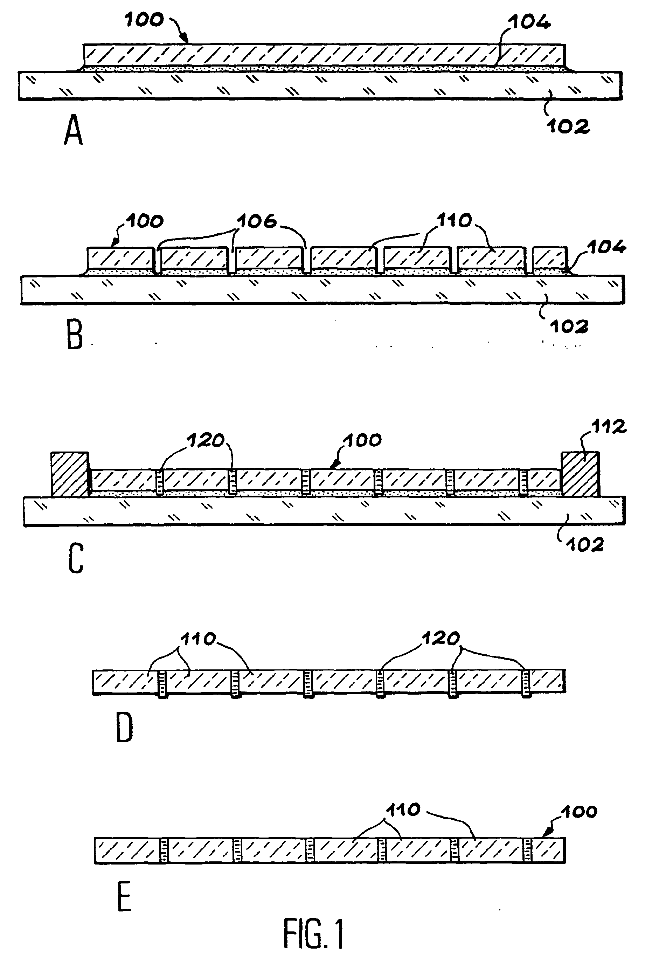

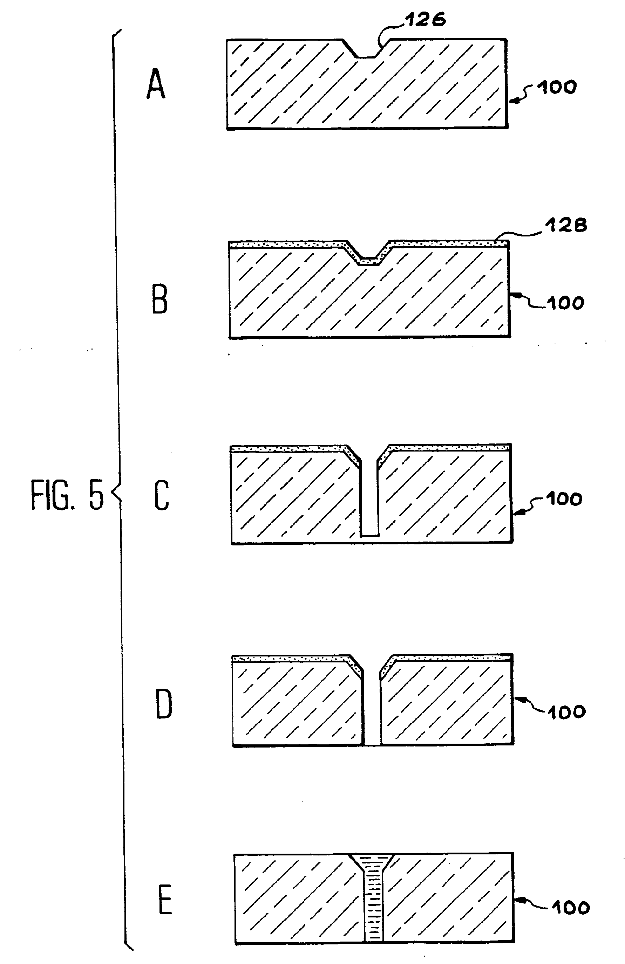

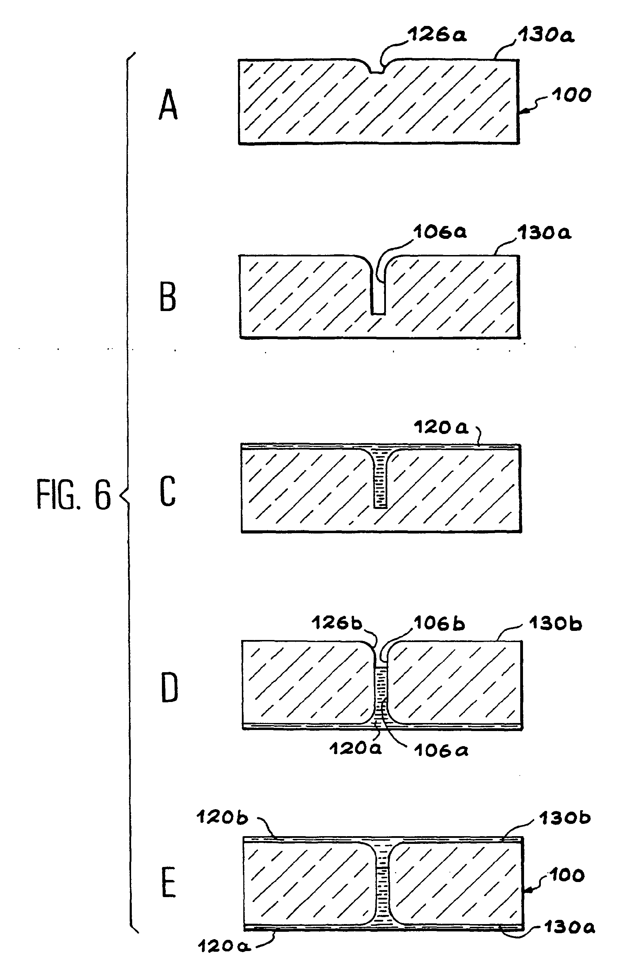

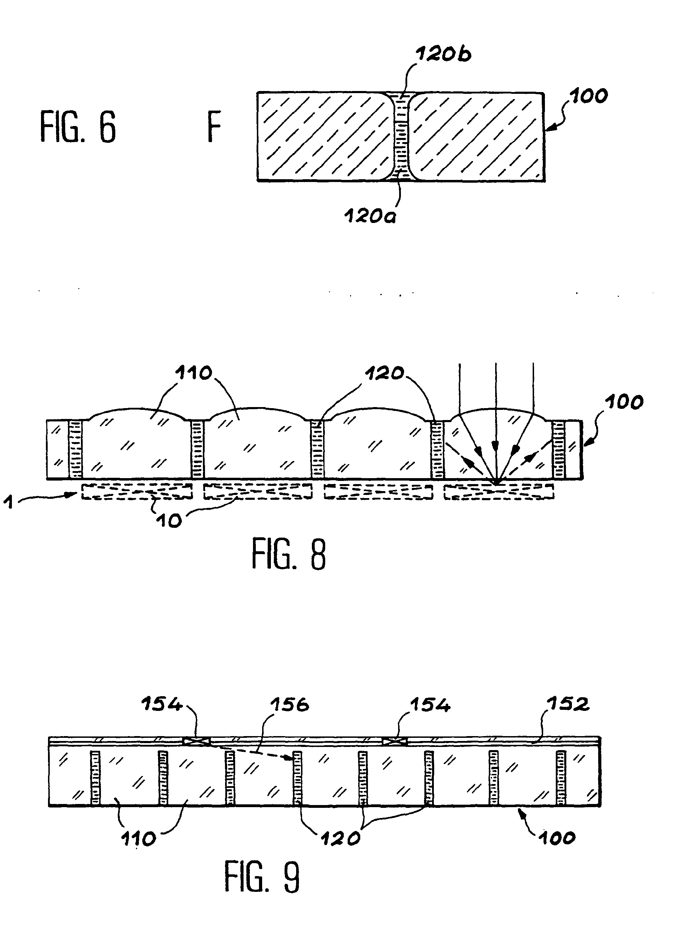

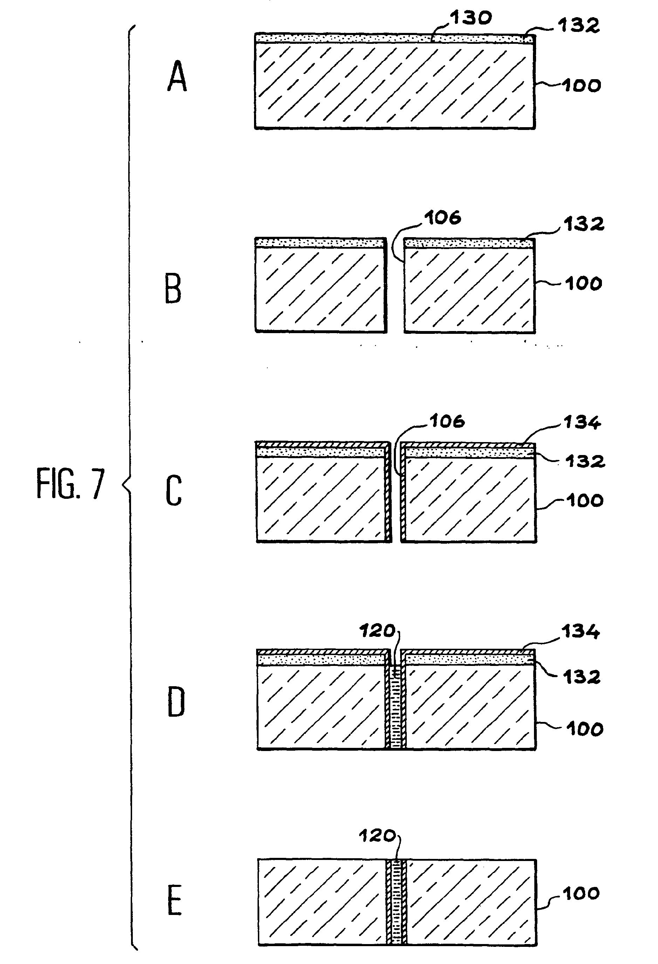

- Les parties A à E de la figure 1 représentent des coupes schématiques d'une plaque de substrat et illustrent des étapes successives d'une mise en oeuvre particulière du procédé de l'invention.

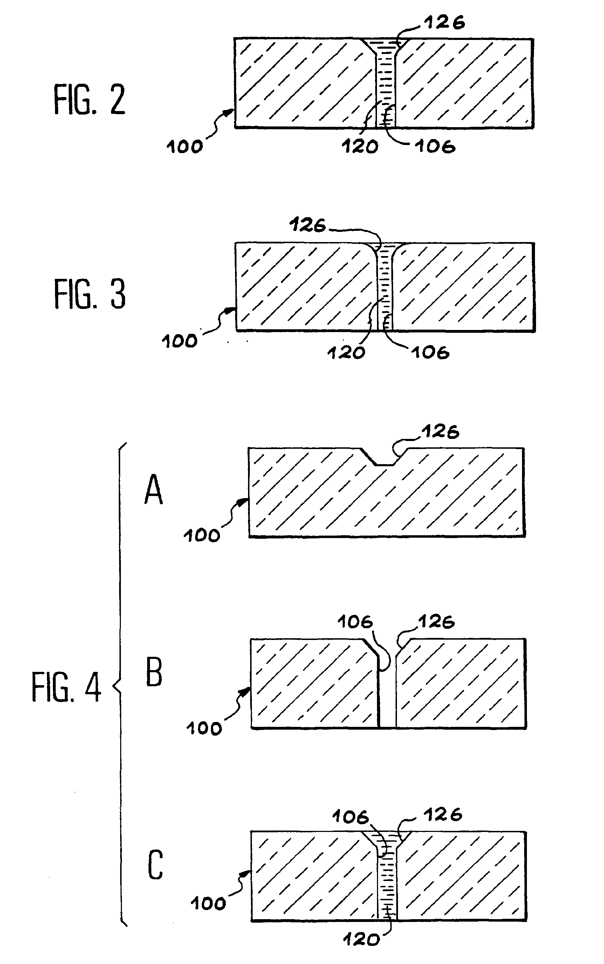

- Les figures 2 et 3 représentent un détail d'une coupe d'une plaque de substrat, illustrant des possibilités de conformation de tranchées d'isolation.
- Les parties A à C de la figure 4 sont des coupes d'un détail d'une plaque de substrat et illustrent des étapes successives de réalisation et de garniture d'une tranchée, conformément à une possibilité de mise en oeuvre particulière du procédé de l'invention.
- Les parties A à E de la figure 5 sont des coupes d'un détail d'une plaque de substrat et illustrent des étapes successives de réalisation et de garniture d'une tranchée, conformément à une autre possibilité de mise en oeuvre particulière du procédé de l'invention.
- Les parties A à F de la figure 6 sont des coupes d'un détail d'une plaque de substrat et illustrent des étapes successives de réalisation et de garniture d'une tranchée, conformément à encore une autre possibilité de mise en oeuvre particulière du procédé de l'invention.
- Les parties A à E de la figure 7 sont des coupes schématiques d'une plaque de substrat et illustrent un perfectionnement possible du procédé de l'invention.
- La figure 8 est une coupe d'une plaque de substrat traitée conformément à l'invention et illustre une application de cette plaque dans le domaine de la micro-optique.
- La figure 9 est une coupe d'une plaque de substrat traitée conformément à l'invention et illustre une application de cette plaque dans le domaine de l'optique guidée.

### Description détaillée de modes de mise en oeuvre de l'invention

Des parties identiques, similaires, ou équivalentes des figures, dont la description suit, sont repérées pour des raisons de simplification par les mêmes références.

La figure 1 montre une mise en oeuvre particulière du procédé de l'invention.

Dans une première étape, correspondant à la partie A de la figure, une plaquette de substrat 100, telle que, par exemple, une tranche de silicium, est fixée sur un support 102 tel qu'une plaque de verre ou de métal par l'intermédiaire d'une couche d'adhésion 104. D'une manière préférée, le matériau du support 102 peut être choisi identique au matériau du substrat 100. Des problèmes sont ainsi évités, du fait que les coefficients de dilatation sont les mêmes. En particulier le matériau du support 102 peut être du silicium quand le substrat 100 est une tranche de silicium.

La couche d'adhésion 104 est par exemple une couche de cire ou de résine permettant un collage réversible. Dans le cas d'une couche de cire, un décollage ultérieur peut être provoqué facilement par une élévation de la température de la couche d'adhésion de quelques dizaines de degrés. Une couche de résine peut être éliminée au moyen d'un solvant approprié.

La plaquette de substrat peut présenter un diamètre variable de quelques centimètres à plusieurs décimètres et une épaisseur de l'ordre de 100 µm à plusieurs millimètres. Elle peut être pourvue de composants préalablement fabriqués ou peut être exempte de composants, ce qui est le cas dans l'exemple de la figure.

Après la mise en place de la plaquette 100 sur le support 102, elle est soumise à un sciage pour y pratiquer des entailles appelées tranchées dans la suite du texte. Une pluralité de tranchées peuvent être formées simultanément en utilisant une scie à plusieurs lames.

Comme le montre la partie B de la figure 1, dans l'exemple décrit, les tranchées 106 traversent de part en part la plaquette de substrat 100.

Les tranchées sont réalisées soit à un pas régulier, soit simplement selon des directions et des distances déterminées au préalable en fonction des composants à réaliser sur le substrat.

Les tranchées 106 présentent une largeur comprise, par exemple, entre quelques dizaines à quelques centaines de micromètres.

La largeur des tranchées peut être ajustée soit en modifiant l'épaisseur des lames utilisées pour le sciage, soit en effectuant plus ou moins de passages successifs d'une même lame de façon légèrement décalée.

On observe que les tranchées délimitent dans le substrat 100 des régions du substrat 110. Ces régions sont destinées à la fabrication ultérieure de composants.

Dans une mise en oeuvre particulière de l'invention où les composants sont réalisés avant la formation des tranchées, des zones dépourvues de composants sont prévues à la surface du substrat pour pouvoir y pratiquer les tranchées.

La partie C de la figure 1 montre la mise en place d'une bordure 112 autour de la plaque de substrat. Dans l'exemple décrit, la plaque de substrat se présente sous la forme d'un disque et la bordure est formée par un simple anneau dont le diamètre intérieur est ajusté au diamètre de la plaque de substrat.

La bordure 112 permet de former avec la plaquette 100 une cuvette pour accueillir un matériau de liaison liquide susceptible de se solidifier et d'adhérer à la plaquette.

Le matériau de liaison, qui porte la référence 120 sur la figure 1 emplit les tranchées 106. Ce matériau, initialement sous forme liquide, est utilisé de préférence en une quantité telle que la surface du liquide affleure juste à la surface libre de la plaque du substrat, sans déborder sur celle-ci. Selon la viscosité du liquide utilisé, sa mise en place dans les tranchées peut être favorisée en appliquant au support 102 une vibration, par exemple ultrasonore.

L'anneau formant la bordure 112 présente de préférence une surface en un matériau, tel que le Téflon, auquel le matériau de liaison n'adhère pas en se solidifiant.

La solidification du matériau de liaison peut avoir lieu, selon le matériau, par exemple, par une réticulation ou polymérisation provoquée par chauffage ou par insolation UV, par catalyse chimique ou par évaporation d'un solvant contenu dans le matériau.

Après la solidification, la couche d'adhésion 104 est chauffée et éliminée de façon à détacher la plaque de substrat 100 du support 102.

On observe sur la partie D de la figure 1 que les régions de la plaque de substrat sont à présent mutuellement isolées par le matériau de liaison 120. De plus, le matériau de liaison assure la cohésion mécanique de la plaque en maintenant les unes contre les autres les régions de substrat 110.

On constate également que le matériau de liaison dépasse légèrement sur la face de la plaquette de substrat initialement collée au support. Ceci tient au fait que les tranchées traversantes pratiquées dans le substrat dépassaient légèrement dans la couche d'adhésion, en raison d'une imprécision de sciage.

Un ébavurage suivi éventuellement d'un léger polissage permet d'obtenir, comme le montre la partie E de la figure 1, une plaque de substrat 100 parfaitement plane avec des régions de substrat 110 physiquement isolées.

Il convient de noter que le procédé de préparation de la plaque de substrat n'a pas modifié la forme de la plaque qui reste par conséquent aux dimensions standardisées des équipements usuels. Elle peut donc être utilisée de façon classique pour la réalisation de composants dans les régions.

En outre, les traitements thermiques mis en oeuvre, notamment pour libérer la plaque de son support sont des traitements à faible température et ne sont donc pas susceptibles d'altérer des composants éventuellement formés au préalable dans la plaque de substrat.

Dans des applications du procédé à l'isolation électrique des régions de substrat, il apparaît que, pour obtenir une tenue en tension élevée entre les régions, l'épaisseur du matériau de liaison dans les tranchées devrait être augmentée.

Des considérations de rendement et de coût de fabrication incitent cependant à réduire au maximum la largeur des tranchées.

Un compromis entre ces deux contraintes peut avantageusement être trouvé en conformant les tranchées de la façon illustrée par les figures 2 et 3.

Conformément à ces figures, les tranchées 106 présentent, en leur extrémité débouchant à la surface de la plaque de substrat, un évasement 126. L'évasement permet d'augmenter davantage la distance entre les arêtes de la plaque de substrat de part et d'autre des tranchées et d'éviter une décharge électrique par ces arêtes qui ont tendance à concentrer les champs électriques.

De préférence, les angles à l'extrémité de la tranchée sont rendus le plus obtus possible, comme le montre la figure 2 ou sont arrondis comme le montre la figure 3.

L'évasement de la figure 2 se présente sous la forme d'un chanfrein. Un tel chanfrein peut être réalisé par une scie de forme dont la lame présente un profil qui détermine la forme de la découpe.

A titre de variante, un évasement conforme à la figure 3 peut aussi être obtenu par gravure. On forme par exemple un masque de gravure en résine sur la surface de la plaque de substrat, à l'exception des tranchées, on provoque un fluage du masque et on procède à une gravure anisotrope.

Une augmentation de la tenue en tension dans le matériau de liaison peut aussi être obtenue en lissant les parois des tranchées.

Ce lissage, peut être réalisé par un second passage de la lame de scie ou d'une autre lame à grains plus fins dans les tranchées, avant la mise en place du matériau de liaison. Il permet d'éliminer des pointes ou des rugosités des parois des tranchées, susceptibles de concentrer le champ électrique de part et d'autre des tranchées entre les régions du substrat.

Les évasements ou chanfreins pratiqués à l'extrémité des tranchées peuvent être réalisées avant ou après les tranchées elles-mêmes. Un exemple de réalisation en est illustré par la figue 4.

La partie A de la figure 4 montre la formation d'une rainure 126 dans une face de la plaque de substrat 100. La rainure 126 est pratiquée par sciage avec une lame à bord oblique afin d'obtenir un chanfrein, en abattant l'arête de la rainure.

La partie B de la figure 4 montre le sciage de la tranchée 106, qui coïncide avec la rainure de telle façon que la tranchée débouche dans la rainure chanfreinée. La tranchée présente une largeur inférieure à la largeur de la partie évasée de la rainure 126. Finalement, le matériau de liaison 120 est introduit dans la tranchée de façon à la combler, y compris dans sa partie supérieure formée par la rainure. Cette dernière étape correspond à la partie C de la figure 4.

La figure 5 montre la mise en oeuvre du procédé selon une variante dans laquelle les tranchées sont réalisées à la fois par sciage et par gravure.

Une première étape, illustrée par la partie A de la figure 5, consiste en la formation d'une rainure 126 dans le substrat. Cette opération, déjà décrite en référence à la partie A de la figure 4, n'est pas reprise ici. On peut noter également que cette étape peut être omise lorsque le matériau de liaison n'est pas destiné à supporter des tensions élevées.

Une seconde étape, illustrée par la partie B de la figure 5 consiste en l'application d'une couche de masque 128 sur la surface du substrat pourvue de la rainure 126. La couche de masque s'étend dans ladite rainure. Il s'agit, par exemple d'une couche de résine.

Le sciage de la tranchée, illustré par la partie C de la figure 5, élimine le masque au fond de la rainure. On observe que le sciage est tel que la tranchée 106 obtenue n'est pas traversante mais s'arrête à faible distance de la face opposée en laissant un reliquat de matière. L'épaisseur du reliquat est, par exemple, de l'ordre de 10 µm. Elle permet d'éviter de faire dépasser la scie au-delà de la plaque du substrat.

La tranchée 106 est achevée par une gravure sèche anisotrope du reliquat de matière laissé après le sciage. Lors de cette gravure, le masque 128 permet de préserver la surface du substrat.

La gravure permet notamment d'arrêter la tranchée de façon plus nette que le sciage.

Cette opération correspond à la partie D de la figure 5.

Une dernière étape, illustrée par la partie E de la figure 5 comprend l'élimination du masque et la garniture de la tranchée de la façon déjà décrite.

La figure 6 montre encore une autre variante de mise en oeuvre du procédé pour l'isolation de régions d'un substrat susceptibles d'être soumises à des inversions de tension. Dans cette variante, les arêtes vives des tranchées sont éliminées des deux côtés de la plaque de substrat.

Une première étape, illustrée par la partie A de la figure 6 consiste à pratiquer dans une première face 130a du substrat une première rainure 126a de forme évasée. Dans l'exemple illustré, les bords de la rainure sont arrondis.

Cette étape est suivie, comme le montre la partie B de la figure 6, par le sciage d'un premier tronçon de tranchée 106a, non traversant, coïncidant avec la rainure.

Le tronçon 106a est rempli avec du matériau de liaison 120a qu'on laisse déborder sur la première face 130a afin de la passiver. Cette opération est représentée à la partie C de la figure 6.

Conformément à la partie D de la figure 6, le substrat est ensuite retourné. Une rainure 126b et un tronçon de tranchée 106b sont pratiqués dans une deuxième face 130b du substrat, opposée à la première face 130a, de façon à coïncider avec le premier tronçon 106a. Le deuxième tronçon de tranchée 106b s'étend jusque sur le matériau de liaison 120a se trouvant dans le premier tronçon de tranchée.

Le deuxième tronçon de tranchée 106b est également empli d'un matériau de liaison 120b qui s'étend jusque sur la deuxième face 130b. On obtient la plaquette de substrat représentée sur la partie E de la figure 6.

La partie F de la figure 6 montre la même plaquette de substrat, pour laquelle le matériau de liaison 120a, 120b ne dépasse pas sur les faces 130a, 130b du substrat.

Une telle plaquette peut être obtenue, par exemple, en décapant les faces 130a, 130b de la plaquette représentée à la partie E.

La figure 7 montre une mise en oeuvre particulière du procédé de l'invention permettant de conférer aux tranchées des propriétés particulières d'isolation optique ou électrique, par exemple.

Une première étape illustrée par la partie A de la figure comprend la formation d'une couche de protection 132 sur une face 130 d'une plaquette de substrat 100.

La couche de protection est, par exemple, une résine, ou un autre matériau pouvant être éliminé par une attaque chimique sélective.

Une deuxième étape, illustrée par la partie B de la figure 7 comprend la formation d'une tranchée 106, de la façon déjà décrite, en référence aux figures 2 à 6.

Une troisième étape, illustrée par la partie C de la figure 7 comprend le dépôt d'une ou de plusieurs couches 134 de matériau de garniture qui tapissent la surface libre de la couche de protection et les parois de la tranchée.

La couche 134 peut être une couche de matériau présentant une résistivité contrôlée pour des applications dans les domaines de l'électronique.

Dans le domaine optique, la couche 134 peut être une couche métallique réfléchissante ou être formée d'une structure multicouche diélectrique avec des propriétés antireflet.

De façon générale, la couche 134 est destinée à conférer aux tranchées des propriétés physiques particulières selon le type d'isolation recherché entre les régions de substrat.

Une étape suivante, illustrée par la partie D de la figure 7 comprend la mise en place du matériau de liaison dans la tranchée.

Enfin, une dernière étape, illustrée par la partie E de la figure 7 comprend l'élimination de la couche de protection et de la partie de la couche de matériau de garniture 134 dépassant hors de la tranchée. La couche de protection peut être éliminée par gravure chimique et la couche de garniture 134 est automatiquement éliminée par un effet de pelage (lift-off).

Lors d'une préparation d'une plaquette de substrat, destinée à recevoir des composants de différentes catégories, il est possible d'équiper les tranchées de différentes couches de garniture, correspondant aux nécessités d'isolation dictées par chaque catégorie de composants.

Les descriptions relatives aux figures 2 à 7 se rapportent explicitement à une seule tranchée pour des raisons de clarté. Il convient cependant de préciser qu'une pluralité de tranchées peuvent être formées simultanément dans une plaque de substrat, par exemple sous la forme d'un réseau orthogonal pour isoler une pluralité de régions de substrat.

La figure 8 montre une application particulière de l'invention dans le domaine de la micro-optique.

Un ensemble de micro-lentilles agencées sous forme de matrice, est constitué par des régions 110 d'un substrat 100 en un matériau transparent à la lumière. La surface supérieure 130 de chaque région 110 présente une courbure qui lui confère ses propriétés de lentille. Dans l'exemple décrit, l'ensemble des micro-lentilles est associé à une matrice de détecteurs 1, dans laquelle chaque détecteur 10 est associé à une région 110, c'est-à-dire à l'une des microlentilles.

Le matériau de liaison 120 utilisé pour garnir les tranchées est un matériau opaque et absorbant utilisé pour éliminer la lumière parasite diffusée sur les détecteurs 10.

La figure 9 montre une autre application de l'invention dans le domaine de l'optique guidée.

Dans cette application, on utilise également un substrat 100 en un matériau transparent à la lumière, dans lequel les tranchées ne sont pas traversantes mais s'étendent sur une partie seulement de l'épaisseur de la plaquette. Les tranchées sont emplies d'un matériau de liaison 120, opaque, permettant d'empêcher la propagation de la lumière. Les tranchées constituent ainsi des isolations optiques comparables à des diaphragmes. La partie du substrat dépourvue de tranchées, appelée superstrat, est repérée avec la référence 150.

Dans le superstrat 150 est formé un guide d'onde optique 152 qui relie entre eux des composants optiques 154. Ces composants sont, par exemple, des miroirs, des réseaux ou des diviseurs optiques.

Le franchissement des composants 154 par une onde optique donne naissance à des pertes optiques, représentées sur la figure de façon schématique sous la forme d'un rayon lumineux 156.

La somme des pertes optiques est susceptible, dans des dispositifs d'optique guidée classiques de produire un bruit de fond gênant pour les composants optiques complexes.

En utilisant un substrat conforme à la figure 9, avec des isolations optiques (diaphragmes) entre différentes régions, il est possible d'arrêter la lumière des pertes optiques et d'obtenir un meilleur rapport de signal sur bruit des composants.

## Revendications

1. Procédé d'isolation physique de régions (110) d'une plaque de substrat (100), comprenant les étapes consécutives suivantes :
a) collage d'une face du substrat, appelée première face, sur un support (102) au moyen d'un matériau adhésif (104) permettant un décollage ultérieur,
b) formation de tranchées (106, 106a, 106b) dans la face du substrat opposée à la première face, appelée seconde face, les tranchées délimitant des régions du substrat (110),
c) mise en place dans les tranchés (106, 106a, 106b) d'un matériau de liaison (120, 120a, 120b) liquide, susceptible d'être solidifié et d'adhérer, à l'état solide, à la plaque de substrat (100),
d) solidification du matériau de liaison.

2. Procédé selon la revendication 1, comprenant en outre, après l'étape d), une séparation du substrat et du support par décollement.

3. Procédé selon la revendication 1 ou 2, dans lequel on pratique les tranchées par sciage.

4. Procédé selon la revendication 1 ou 2, dans lequel le matériau de liaison (120, 120a, 126) est un matériau diélectrique.

5. Procédé selon la revendication 4, dans lequel le matériau de liaison diélectrique est un matériau polymère, sol-gel, ou un matériau époxy.

6. Procédé selon la revendication 1, dans lequel on dispose autour de la plaque une bordure (112), amovible, en un matériau auquel le matériau de liaison n'adhère pas, afin de former une cuvette de réception dudit matériau de liaison.

7. Procédé selon la revendication 1, comprenant en outre après l'étape c) une étape d'ébavurage du matériau de liaison, dépassant hors des tranchées.

8. Procédé selon la revendication 3, dans lequel le sciage des tranchées est suivi d'un lissage des parois des tranchées.

9. Procédé selon la revendication 1, dans lequel on pratique au moins un évasement (126, 126a, 126b) à au moins une extrémité des tranchées avant la mise en place du matériau de liaison.

10. Procédé selon la revendication 9, dans lequel on pratique dans la plaque de substrat des rainures à flancs obliques formant lesdits évasements (126).

11. Procédé selon la revendication 9, dans lequel les évasements (126) sont formés par gravure ou par sciage.

12. Procédé selon la revendication 9, dans lequel les évasements (126) sont formés avant les tranchées.

13. Procédé selon la revendication 9, dans lequel les évasements (126) sont formés après les tranchées.

14. Procédé selon la revendication 9, dans lequel on pratique des évasements (126a, 126b) à chaque extrémité des tranchées, sur la première et la seconde faces (130a, 130b) de la plaque de substrat.

15. Procédé selon la revendication 14, comprenant les étapes suivantes :
- formation de premières rainures (126a) à flancs évasés dans la première face (130a) de la plaque de substrat,
- formation à partir de la première face de premières tranchées non traversantes (106a) dans la plaque, coïncidant avec les premières rainures,
- garniture des premières tranchées (106c) avec du matériau de liaison (120a),
- décollement du substrat et du support,
- formation de deuxièmes rainures (126b) à flancs évasés dans la deuxième face (130b) de la plaque de substrat, opposée à ladite première face, les deuxièmes rainures étant colinéaires aux premières rainures,
- formation à partir de la deuxième face (130b) de deuxièmes tranchées (106b) coïncidant avec les deuxième rainures et débouchant dans les premières tranchées,
- garniture des deuxièmes tranchées (106b) de matériau de liaison (120b).

16. Procédé selon la revendication 1, dans lequel, avant la mise en place du matériau de liaison dans les tranchées on tapisse des parois des tranchées avec un revêtement (134).

17. Procédé selon la revendication 16, dans lequel le revêtement (134) est une couche de matériau conducteur électrique.

18. Procédé selon la revendication 17, dans lequel le revêtement (134) est un revêtement optique multicouche.

19. Utilisation d'une plaque de substrat obtenue selon le procédé de la revendication 1, pour la réalisation de composants dans les régions de la plaque de substrat, les composants étant réalisés avant ou après la mise en oeuvre du procédé.

20. Utilisation d'une plaque de substrat obtenue selon le procédé de la revendication 1 pour la fabrication de barrettes ou de matrices de diodes ou de transistors isolés les uns des autres.

21. Utilisation d'une plaque de substrat obtenue selon le procédé de la revendication 1 pour la fabrication de barrettes ou de matrices de circuits électroniques isolés électriquement les uns des autres.

22. Utilisation d'une plaque de substrat obtenue selon le procédé de la revendication 1 pour la fabrication d'un composant formé de diodes et/ou de transistors, et/ou de circuits électroniques, et/ou de capteurs ou actionneurs, isolés les uns des autres.

23. Utilisation d'une plaque de substrat obtenue selon le procédé de la revendication 1, comme support de guide optique.

24. Utilisation d'une plaque de substrat obtenue selon le procédé de la revendication 1, pour la fabrication d'une matrice de microlentilles, chaque région de la plaque formant une microlentille de la matrice.

## Claims

1. Process for physical isolation of regions (110) of a substrate board (100) comprising the following consecutive steps:
a) bonding of a face of the substrate, named first face, onto a support (102) using an adhesive means (104) that can be subsequently unbonded,
b) formation of trenches (106, 106a, 106b) in the face of the substrate opposed to the first face, named second face, the trenches delimiting regions of the substrate (110),
c) placement of a liquid bonding material (120, 120a, 120b) in the trenches (106, 106a, 106b), which can solidify and bond to the substrate board (100) when in the solid state,
d) solidification of the bonding material.

2. Process according to claim 1, also comprising a separation of the substrate and the support by unbonding, after step d).

3. Process according to claim 1 or 2, in which trenches are formed by sawing.

4. Process according to claim 1 or 2, in which the bonding material (120, 120a, 126) is a dielectric material.

5. Process according to claim 4, in which the dielectric bonding material is a polymer, sol-gel, or epoxy material.

6. Process according to claim 1, in which a removably border (112) is formed around the wafer made of a material to which the bonding material will not bond, in order to form a reception tray for the said bonding material.

7. Process according to claim 1, also including a step to deburr the bonding material that projects outside the trenches, after step c).

8. Process according to claim 3, in which the sides of the trenches are smoothed after the trenches have been sawn.

9. Process according to claim 1, in which at least one flare (126, 126a, 126b) is formed at least one end of the trenches, before the bonding material was put into place.

10. Process according to claim 9, in which grooves with oblique sides are made to form the said flares (126).

11. Process according to claim 9, in which the flares (126) are formed by etching or sawing.

12. Process according to claim 9, in which the flares (126) are formed before the trenches.

13. Process according to claim 9, in which the flares (126) are formed after the trenches.

14. Process according to claim 9, in which the flares (126a, 126b) are formed at each end of the trenches, on the first and second face (130a, 130b) of the substrate board.

15. Process according to claim 14, comprising the following steps:
- form first grooves (126a) with flared sides on the first face (130a) of the substrate board,
- form first non-through trenches (106a) in the board starting from the first face, coinciding with the first grooves,
- apply a coat of bonding material (120a) on the first trenches (106c),
- separate the substrate and the support,
- form second grooves (126b) with flared edges on the second face (130b) of the substrate board, opposite the said first face, the two grooves being collinear with the first grooves,
- form second trenches (106b) starting from the second face (130b) coinciding with the second grooves and leading intro the first trenches,
- apply a coat of bonding material (120b) on the second grooves (106b).

16. Process according to claim 1, in which the sides of the trenches are lined with a coating (134) before the bonding material is placed in the trenches.

17. Process according to claim 16, in which the coating (134) is a coat of electrically conducting material.

18. Process according to claim 17, in which the coating (134) is a multi-layer optical coat.

19. Use of a substrate board obtained by the process according to claim 1, to produce components in regions of the substrate board, the components having been made before or after implementation of the process.

20. Use of a substrate board obtained according to the process described in claim 1 to make strips or matrices of diodes or transistors insulated from each other.

21. Use of a substrate board obtained according to the process described in claim 1 to make strips or matrices of electronic circuits insulated from each other.

22. Use of a substrate board obtained according to the process described in claim 1 to make a component formed of diodes and/or transistors, and/or electronic circuits, and/or sensors or actuators, isolated from each other.

23. Use of a substrate board obtained according to the process described in claim 1, as an optical support guide.

24. Use of a substrate board obtained according to the process described in claim 1, to make a matrix of microlenses, each region of the board forming a microlens of the matrix.

## Patentansprüche

1. Verfahren zur physikalischen Isolation von Bereichen (110) einer Substratplatte (100), das die folgenden aufeinander folgenden Schritte umfasst:
a) Kleben einer Fläche des Substrats, die erste Fläche genannt wird, auf einen Träger (102) mithilfe eines Klebmaterials (104), das ein späteres Ablösen ermöglicht,
b) Bilden von Gräben (106, 106a, 106b) in der Fläche des Substrats, die der erste Fläche gegenüberliegt und die zweite Fläche genannt wird, wobei die Gräben Bereiche des Substrats (110) abgrenzen,
c) Einbringen eines flüssigen Verbindungsmaterials (120, 120a, 120b) in die Gräben (106, 106a, 106b), das verfestigt werden kann und im festen Zustand an der Substratplatte (100) festkleben kann,
d) Verfestigen des Verbindungsmaterials.

2. Verfahren nach Anspruch 1, das außerdem nach dem Schritt d) eine Trennung des Substrats und des Trägers durch Ablösen umfasst.

3. Verfahren nach Anspruch 1 oder 2, wobei die Gräben durch Sägen hergestellt werden.

4. Verfahren nach Anspruch 1 oder 2, wobei es sich bei dem Verbindungsmaterial (120, 120a, 126) um ein dielektrisches Material handelt.

5. Verfahren nach Anspruch 4, wobei es sich bei dem dielektrischen Verbindungsmaterial um ein Polymermaterial, ein Sol-Gel oder ein Epoxidmaterial handelt.

6. Verfahren nach Anspruch 1, wobei um die Platte ein abnehmbarer Rand (112) aus einem Material angeordnet ist, an dem das Verbindungsmafierial nicht festklebt, um eine Schüssel zum Aufnehmen des Verbindungsmaterials zu bilden.

7. Verfahren nach Anspruch 1, das außerdem nach dem Schritt c) einen Schritt des Entgratens des Verbindungsmaterials umfasst, das aus den Gräben hinausragt.

8. Verfahren nach Anspruch 3, wobei das Sägen der Gräben nach einem Glätten der Wände der Gräben erfolgt.

9. Verfahren nach Anspruch 1, wobei mindestens eine Ausweitung (126, 126a, 126b) an mindestens einem Ende der Gräben vor dem Einbringen des Verbindungsmaterials hergestellt wird.

10. Verfahren nach Anspruch 9, wobei in der Substratplatte Nuten mit schrägen Seiten hergestellt werden, die die Ausweitungen (126) bilden.

11. Verfahren nach Anspruch 9, wobei die Ausweitungen (126) durch Ätzen oder durch Sägen gebildet werden.

12. Verfahren nach Anspruch 9, wobei die Auswertungen (126) vor den Gräben gebildet werden.

13. Verfahren nach Anspruch 9, wobei die Ausweitungen (126) nach den Gräben gebildet werden.

14. Verfahren nach Anspruch 9, wobei die Ausweitungen (126a, 126b) an jedem Ende der Gräben, auf der ersten und der zweiten Fläche (130a, 130b) der Substratplatte hergestellt werden.

15. Verfahren nach Anspruch 14, das die folgenden Schritte umfasst:
- Bilden von ersten Nuten (126a) mit ausgeweiteten Seiten in der ersten Fläche (130a) der Substratplatte,
- Bilden von ersten, nicht durchgehende Gräben (106a) von der ersten Fläche ausgehend in der Platte, die mit den ersten Nuten zusammenfallen,
- Ausstatten der ersten Gräben (106c) mit dem Verbindungsmaterial (120a),
- Ablösen des Substrats und des Trägers,
- Bilden von zweiten Nuten (126b) mit ausgeweiteten Seiten in der zweiten Fläche (130b) der Substratplatte, die der ersten Fläche gegenüberliegt, wobei die zweiten Nuten mit den ersten Nuten kollinear sind,
- Bilden von zweiten Gräben (106b) von der zweiten Fläche (130b) ausgehend, die mit den zweiten Nuten zusammenfallen und in den ersten Gräben münden,
- Ausstatten der zweiten Gräben (106b) mit dem Verbindungsmaterial (120b).

16. Verfahren nach Anspruch 1, wobei vor dem Einbringen des Verbindungsmateriafs in die Gräben die Wände der Gräben mit einer Beschichtung (134) bedeckt werden.

17. Verfahren nach Anspruch 16, wobei es sich bei der Beschichtung (134) um eine Schicht aus elektrisch leitendem Material handelt.

18. Verfahren nach Anspruch 17, wobei es sich bei der Beschichtung (134) um eine optische Beschichtung aus mehreren Schichten handelt.

19. Verwendung einer nach dem Verfahren nach Anspruch 1 erhaltenen Substratplatte zur Herstellung von Bauelementen in den Bereichen der Substratplatte, wobei die Bauelemente vor oder nach dem Durchführen des Verfahrens hergestellt werden.

20. Verwendung einer nach dem Verfahren nach Anspruch 1 erhaltenen Substratplatte zur Herstellung von Anschlussleisten oder Diodenmatrizes oder Transistoren, die voneinander isoliert sind.

21. Verwendung einer nach dem Verfahren nach Anspruch 1 erhaltenen Substratplatte zur Herstellung von Spangen oder elektronischen Schaltungsmatrizes, die voneinander elektrisch isoliert sind.

22. Verwendung einer nach dem Verfahren nach Anspruch 1 erhaltenen Substratplatte zur Herstellung eines Bauelements, das von Dioden und/oder Transistoren und/oder elektronischen Schaltungen und/oder Gebern oder Akteuren gebildet wird, die voneinander isoliert sind.

23. Verwendung einer nach dem Verfahren nach Anspruch 1 erhaltenen Substratplatte als optischer Lichtwellenleiterträger.

24. Verwendung einer nach dem Verfahren nach Anspruch 1 erhaltenen Substratplatte zur Herstellung einer Mikrolinsenmatrix, wobei jeder Bereich der Platte eine Mikrolinse der Matrix bildet.
